# EUROPEAN PATENT APPLICATION

(11) **EP 1 035 623 A1**
(43) Date of publication of application: **13.09.2000**
(21) Application number: 98870265.0
(22) Date of filing: 04.12.1998
(51) Int. Cl.: H01S 5/026, H01S 3/0941

(54) **A device for emitting electromagnetic radiation and a method of producing such device**

(71) Applicant: INTERUNIVERSITAIR MICRO-ELEKTRONICA CENTRUM VZW, 3001 Heverlee (BE)
(72) Inventor: Van Hoof, Chris, 3010 Leuven(Kessel-Lo) (BE); Borghs, Gustaaf, 3001 Kessel-Lo (BE)
(74) Representative: Van Malderen, Joelle

(57) **Abstract**

A device for emitting electromagnetic radiation at a predetermined wavelength, said device comprising a substrate including a laser structure (20) optically pumped by a light-emitting diode (10), both being in a monolithic structure on the same substrate (05).

## Description

### Field of the invention

The present invention is related to the field of devices emitting electromagnetic radiation. More particularly, the present invention is related to a semiconductor device that lases in the infrared. A method of producing such device and applications of such device are also disclosed.

### Background of the invention

Semiconductor devices that emit non-coherent or coherent electromagnetic radiation are known in the art. The laser medium (solid, liquid or gas) is either electrically pumped (e.g. diode lasers) or optically pumped (e.g. solid-state lasers) by means of separate lamps or a separate laser which can either be a diode laser or a solid-state laser. The laser medium is placed inside a resonator, which tends to be large in case of solid-state lasers, and microscopically small in case of diode lasers.

The concept of using a separate optical source for the pumping is also well established, most notably in all large-frame lasers, even though recent microchip lasers and other compact lasers have also been pumped by diode lasers (US-A-5159605). In all cases, the optical pump source exits the material where it originates and either travels through free space as described in EP-A-0665616 or through a waveguide or fiber as described in US-A-4847851.

It is also known by EP-A-0047601 to have an electrically-pumped diode laser wherein the laser is simultaneously pumped by a monolithically-integrated LED source for reducing the response time of the laser.

When using diode lasers or solid-state lasers for optical pumping use of the free space is not problematic. Replacing these lasers by LEDs does not work well in the existing configurations, because of the low output power of the LEDs. This stems from total internal reflection at the semiconductor-air interface which limits the external efficiency of LEDs to approximately 2% in spite of the near unity internal quantum efficiency. In spite of the low efficiency, several optically-pumped lasers have been proposed in EP-A-0078941 that employ external light-emitting diodes.

Optical pumping has an added benefit over electrical pumping in semiconductor laser diodes since the output power and the emission wavelength are not irrevocably linked. The optical pump source will determine the output of the laser and the laser medium or the laser cavity can be independently modified (by means of a voltage, pressure, orientation, size, ...) to provide wavelength control.

Mid-infrared diode lasers suffer much more than their counterparts in the near-infrared from non-radiative Auger recombination. This competing mechanism to radiative recombination raises the threshold current density and limits the operating temperature of these lasers. Strain and bandgap engineering has been used in US-A-5625635 to alleviate this problem. In addition, achieving low-resistivity contact and cladding layers is very difficult using the mid-infrared III-V materials (e.g. Nemeth-S et al., Jap. J. Appl. Phys. 36, 3426 (1997)). The combination of high threshold current and high-resistivity contact layers is very problematic since it causes excessive heating.

### Aims of the invention

The present invention is related to optical pumping devices using efficient external lasers which would overcome the problem of excessive heating. Monolithic optical pumping would be even more beneficial if LED sources are used.

Optical pumping of laser structures is also performed in the initial development of a new laser diode as the active layer can be pumped by an external laser wherein the problem of contact resistivity can be avoided. This is particularly the case for mid-infrared laser diodes so one can concentrate on the improvement of the active medium first.

By using optical sources for pumping laser structures, the presence of dopants in the cladding layer of the laser structure can be avoided. Such dopants which are used in nearly all prior art laser structures, lead to optical losses due to free carrier absorption.

Therefore, it is an aim of the present invention to provide a semiconductor-based device for emitting electronic radiation preferably in the infrared which does not show the problems of the art described hereabove.

More particularly, the main aim of the present invention is to suggest a device which is optically pumped by a laser diode and which can have the output power and the emission wavelength, not irrevocably linked.

Furthermore, the present invention aims to suggest a device which will overcome the problems of the combination of high threshold current and high resistivity contact layer.

### Summary of the invention

The present invention is related to a device for emitting electromagnetic radiation at a predetermined wavelength, said device comprising a substrate including a laser structure optically pumped by a light-emitting diode, both devices being in a monolithic structure on the same substrate. Said light-emitting device and said laser structure are in immediate contact.

According to preferred embodiments, said light-emitting diode is grown on the same substrate below or above said laser structure.

According to another preferred embodiment, said light-emitting diode is grown on the same substrate just adjacent to said laser structure. In that case, the medium present between both devices has substantially the same refraction index as the substrate whereon said devices are grown.

By not crossing air-semiconductor interface, total internal reflection is avoided and nearly all LED light can be used for optical pumping of the infrared active medium. As a consequence, the efficiency of the optical pumping is more than one order of magnitude higher than in case of external LEDs and even surpasses that of external diode-laser excitation. In addition, independent wavelength and power control are obtained.

Because the pumping method is optical pumping, the waveguide / cladding layer can be left undoped, thereby minimising free carrier absorption losses.

Preferably, said laser structure comprises a bottom cladding layer, a mid-IR active layer, and a top cladding layer, said structure having its facets on the form of a mirror.

Preferably, said double light-emitting diode consists essentially of a Near-IR DH LED comprised between a top contact layer and a bottom contact layer, having top LED and bottom LED electrodes to the top contact layer and the bottom contact layer respectively.

According to one preferred embodiment, a bottom LED mirror is provided under the bottom contact layer, in case that the LED diode is below the laser structure.

A top LED mirror is provided on the top contact layer in case that the light-emitting diode is above the laser structure.

A second object of the present invention is to suggest a method of producing a device for emitting electromagnetic radiation, wherein said LED diode is monolithically grown on said laser structure or wherein said laser structure is monolithically grown on said LED diode.

According to a first preferred embodiment of the present invention, the method comprises the steps of :
- making on a substrate a LED diode by growing first a bottom LED mirror, a bottom contact layer, a Near-IRDH LED layer, and a top contact layer;
- depositing a spacer layer;
- directly on the top of said spacer layer; making a laser diode by growing a bottom cladding layer, a mid-IR active layer, and a top cladding layer;
- depositing ohmic contacts to the LED;
- cleaving the facets of said laser structure.

Alternatively, according to another preferred embodiment of the present invention, the method comprises the steps of:
- making a laser structure by growing a bottom cladding layer, a mid-IR active layer, and a top cladding layer;
- depositing a spacer layer;
- directly on the top of said spacer layer; making a LED diode by growing a bottom contact layer, a Near-IRDH LED layer, and a top layer contact, as well as a top LED mirror;
- depositing ohmic contacts on the LED;
- cleaving the facets of said diode structure.

### Brief description of the drawings

The present invention will be described in details with reference to the following drawings, wherein :
- Figure 1: is describing a first preferred embodiment of the device according to the invention, wherein a laser structure is grown on a LED.
- Figure 2: is describing a second preferred embodiment of the device according to the invention, wherein LED is grown on a laser structure.
- Figure 3: is describing a third embodiment of the device according to the invention, wherein the LED is adjacent to the laser structure.

### Detailed description of the preferred embodiments of the present invention

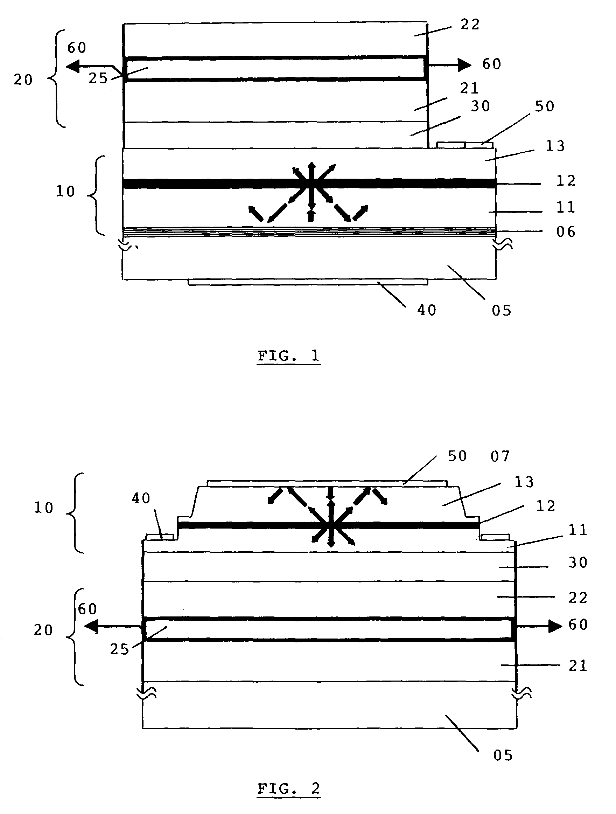

The present invention is described in detail in the following sequel. Two preferred embodiments are disclosed in Figures 1 and 2.

An example embodiment is shown in Figure 1. It consists of a state-of-the-art III-V light-emitting diode (LED) with the general reference 10 grown by established means (MBE or MOCVD) on a matched or dissimilar substrate. As 50 % of the generated light is sent downwards to the substrate, a bottom mirror 06 is grown (e.g. a distributed Bragg Reflector, DBR) to reflect that fraction of the light. The internal quantum efficiency of such LED approaches 100% which is approximately 50 times higher than the external quantum efficiency after crossing the semiconductor-air interface. Directly on top of the LED structure a mid-infrared laser diode structure 20 is grown with undoped cladding layers 21 and 22 for waveguiding purposes. In addition, a spacer layer 30 has to be grown between LED structure 20 and laser diode structure 10 to accommodate the possible lattice mismatch between the near-infrared LED material and the mid-infrared laser diode material. Furthermore, this spacer layer 30 and bottom cladding layer 21 ensemble has to be transparent to the near-infrared radiation from the LED and the index of refraction of the layer or multilayer sequence has to be such that reflection of the LED light is minimised while at the same escape of the mid-infrared light is prevented. The mid-infrared active layer 25 absorbs the near-infrared LED light and mid-infrared photoluminescence will result. Under the appropriate LED pumping conditions (temperature, current, pulse duration, current density) lasing conditions can be achieved for the mid-infrared laser diode structure in a similar way to external pumping but with lower required pump power.

A scheme where the mid-infrared laser structure is grown first on its substrate followed by a state-of-the-art LED is also possible (figure 2). In this case, a top mirror 50 has to be used for sending the LED light to the infrared laser structure. This can be accomplished by means of a metal mirror evaporated on the top cladding layer.

It is well known that near-IR LED characteristics can be significantly improved using current confinement by means of lateral oxidation of a confinement layer and this can be applied here.

In the final stage, the laser is then processed into a stripe or ridge geometry and ohmic contacts are deposited (evaporated or plated) on the LED part for electrical pumping. The facets are created by cleaving. Well-known techniques for cooling the apparatus during operation are applied.

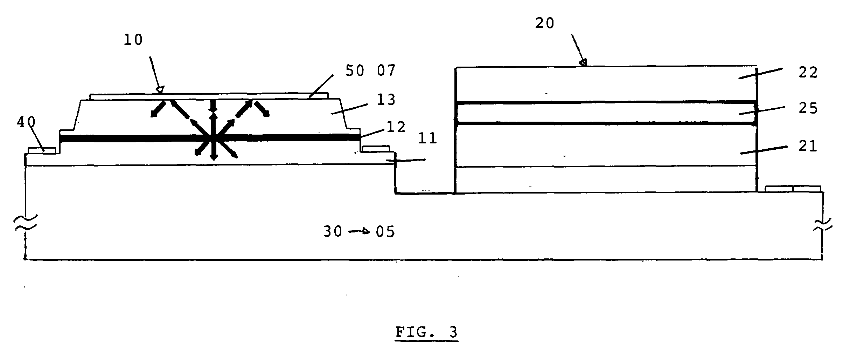

Figure 3 is describing an alternative embodiment of the present invention wherein the LED is adjacent to the laser structure. However, in this specific embodiment, the medium present between both devices should have substantially the same refraction index as the substrate whereon both devices are grown.

## Claims

1. A device for emitting electromagnetic radiation at a predetermined wavelength, said device comprising a substrate including a laser structure (20) optically pumped by a light-emitting diode (10), both being in a monolithic structure on the same substrate (05).

2. A device according to claim 1, wherein said light-emitting diode (10) is in immediate contact with said laser structure (20).

3. A device according to claim 1 or 2, wherein said light-emitting diode (10) is grown on the same substrate below or above the laser structure (20).

4. A device according to claim 1 or 2, wherein said light-emitting diode (10) is grown on the same substrate just adjacent to said laser structure (20).

5. A device according to claim 4, wherein the medium present between said light-emitting diode and said laser structure has substantially the same refraction index as the substrate whereon said light-emitting diode and said laser structure are grown.

6. A device according to any one of the preceding claims, wherein said laser structure is essentially undoped.

7. A device according to any one of the preceding claims, wherein a contact layer (30) is created between the light-emitting diode (10) and the laser structure (20).

8. A device according to any one of the preceding claims, wherein the laser structure (20) comprises a bottom cladding layer (21), a mid-IR active layer (25), and a top cladding layer (22), said structure having its facets on the form of a mirror (60).

9. A device according to any one of the preceding claims, wherein the top and bottom cladding (21, 22) layers are undoped layers.

10. A device according to any one of the preceding claims, wherein the light-emitting diode (10) consists essentially in a Near-IRDH LED (12) comprised between a top contact layer (13) and a bottom contact layer (11), having top LED and bottom LED electrodes (40, 50) to the top contact layer and the bottom contact layer respectively.

11. A device according to any one of the preceding claims, wherein a bottom LED mirror (06) is provided under the bottom contact layer (11), in case that the LED diode is below the laser structure.

12. A device according to any one of the preceding claims, wherein a top LED mirror (07) is provided on the top contact layer (13) in case that the light-emitting diode is above the laser structure.

13. A method of producing a device for emitting electromagnetic radiation, wherein a light-emitting diode is monolithically grown on a laser structure.

14. A method according to claim 13, comprising the steps of:
- making a laser structure by growing a bottom cladding layer, a mid-IR active layer, and a top cladding layer;
- depositing a spacer layer;
- directly on the top of said spacer layer;
- making a LED diode by growing a bottom contact layer, a near-IRDH LED layer, and a top layer contact, as well as a top LED mirror;
- depositing ohmic contacts to the LED;
- cleaving the facets of said laser structure.

15. A method of producing a device for emitting electromagnetic radiation, wherein a laser structure is monolithically grown on light-emitting diode.

16. A method according to claim 15, comprising the steps of:
- making on a substrate a LED diode by growing first a bottom LED mirror, a bottom contact layer, a Near-IRDH-LED layer, and a top contact layer;
- depositing a spacer layer;
- directly on the top of said spacer layer;
- making a laser diode by growing a bottom cladding layer, a mid-IR active layer, and a top cladding layer;
- depositing ohmic contacts to the LED;
- cleaving the facets of said laser structure.
